# EUROPEAN PATENT SPECIFICATION

(11) **EP 1 695 549 B1**
(45) Date of publication and mention of the grant of the patent: **11.08.2010**
(21) Application number: 04799361.3
(22) Date of filing: 17.11.2004
(51) Int. Cl.: H04N 5/228, H04N 5/335, H04N 3/15

(54) **METHOD AND APPARATUS FOR CAMERA SHAKE COMPENSATION**
VERFAHREN UND VORRICHTUNG ZUR KOMPENSATION VON KAMERAZITTERN
PROCEDE ET APPAREIL PERMETTANT DE COMPENSER LES SECOUSSES D'UNE CAMERA

(30) Priority: 11.12.2003 US 528510 P; 23.01.2004 US 538517 P
(43) Date of publication of application: 30.08.2006
(73) Proprietor: Advasense Technologics (2004) Ltd., 46120 Herzeliya (IL)
(72) Inventor: BARON, Natan, 44813 Oranit (IL); KOIFMAN, Vladimir, 75575 Rishon Lezion (IL)
(74) Representative: Wray, Antony John
(86) International application number: PCT/IL2004/001054
(87) International publication number: WO 2005/057902

(56) References cited:
- GB-A- 2 162 019
- GB-A- 2 261 341
- GB-A- 2 302 472
- JP-A- 2001 358 999
- US-A- 5 452 004
- US-A- 5 892 540
- US-A1- 2002 060 741
- US-B1- 6 326 230
- US-B1- 6 525 770
- US-B2- 6 801 255

## Description

### Field of the invention

The invention relates to a method and apparatus for camera shake compensation and especially for compensating shakes in a CMOS pixel array.

### Background of the invention

Digital cameras include a two-dimensional pixel array. Each pixel includes a light sensitive elements that convert photons to an analog signal. The light sensitive elements can include photodiodes, phototransistors, photogates, hole accumulation diodes, pinned diodes, avalanche diodes, buried accumulation and transfer layer devices.

Various prior art pixels are known. The most commonly used pixels are either CCD pixels or CMOS pixels. Prior art CMOS pixels and two dimensional CMOS arrays are illustrated in the following U.S. patents which are incorporated-herein by reference: U.S. patent 6777660 of Lee, titled "CMOS active pixel reset noise reduction"; U.S. patent 6762401 of Lee, titled "CMOS image sensor capable of increasing fill factor and driving method thereof"; U.S. patent 6707495 of Harada titled "solid-state imaging device and a method of reading a signal charge in a solid-state imaging device which can reduce smear and can provide an excellent image characteristics"; U.S. patent 6750912 of Tennant et al., titled "Active-passive imager pixel array with small groups of pixels having short common bus lines"; U.S. patent 6697111 of Kozlowski et al., titled "compact low-noise active pixel sensor with progressive row reset"; U.S. patent 6665013 of Fossum et al., titled "active pixel sensor having intra-pixel charge transfer with analog-to-digital converter"; U.S. patent 6587142 of Kozlowski et al., titled "low-noise active-pixel sensor for imaging arrays with high speed row reset"; U.S. patent 6538245 of Kozlowski, titled "amplified CMOS transducer for single photon read-out of photodetectors"; U.S. patent 6532040 of Kozlowski et al., titled "low-noise active-pixel sensor for imaging arrays with high-speed row reset"; U.S. patent 5892540 of Kozlowski et al., titled "low noise amplifier for passive pixel CMOS imager"; U.S. patent 6438276 of Dhuse et al., titled "imaging system having a sensor array reset noise reduction mechanism" and U.S. patent 6326230 of Pain et al., titled "high speed CMOS imager with motion artifact suppression and anti-blooming".

Each pixel provides an analog signal in response to light that interacts with the light sensitive element. Due to various reasons each pixel has to receive at least a minimal amount of photons in order to provide a reasonable analog signal. This minimal amount of photons dictates an exposure period that is inversely proportional to the light intensity. In other words, smaller amounts of light result in longer exposure periods.

Relative movement between an object and the pixel array can result from movements of the object or from movement of the camera. The latter can increase as the size of cameras, especially cameras that are integrated in mobile devices such as cellular phones, decreases. This relative movement is known as camera shake.

This relative movement can cause unwanted effects such as picture blur, especially when the exposure period is not short enough in relation to that relative movement. Typically, if during the exposure period the image moves by a distance that exceeds about a half of a pixel the acquired picture is regarded as blurred.

Various method and systems for compensating for camera shake are known in the art. They usually include altering an optical characteristic of the camera, moving a certain lens and the like.

High cost telescopes compensate for air turbulence induced image errors by a costly mechanism that includes dividing an exposure period to provide multiple snapshots that are digitally stored in large memory arrays and are added to each other in complex digital circuits that include large external memories (as multiple image, each including many pixels, has to be stored), very fast buses and complex signal processing logic. It is further noted that the transmission of high-speed signals over fast buses can result in RFI problems.

There is a need to provide an efficient method and apparatus for compensating for camera shake. US6525770 refers to the initial value T0 of the period of a four-phase driving signal for driving a CCD of an image pickup device is calculated according to the equation T0=(Lxp)/(fxv). GB2303472 refers to an imaging system compensates for relative motion of the imaging system with respect to a scene to be captured.

### SUMMARY OF THE INVENTION

The invention provides a method and an apparatus for camera shake compensation, according to the appended claims.

### BRIEF DESCRIPTION OF THE DRAWINGS

The present invention will be understood and appreciated more fully from the following detailed description taken in conjunction with the drawings in which:

Figure 1 is a schematic diagram of an apparatus for camera shake compensation, according to an embodiment of the invention;

Figure 2 is a schematic illustration of a cell of the picture shift unit, according to an embodiment of the invention;

Figure 3 is a schematic illustration of a cell of a picture shift unit, according to an embodiment of the invention;

Figures 4 and 5 illustrate pixels according to various embodiments of the invention; and

Figure 6 is a flow chart illustrating a method for acquiring a picture, according to an embodiment of the invention.

### DETAILED DESCRIPTION OF THE DRAWINGS

The invention provides an apparatus and method for receiving an analog signal representative of received light by a certain pixel, and shifting it to another pixel. One of the embodiments of invention includes reading the pixel, storing it to an analog memory and writing it back to another pixel It is noted that the analog signal generated by the light sensitive element can be converted, altered, amplified and the like during the read out, storage and write back operation. These modifications and/or alterations still provide an analog signal representative of the received light. For simplicity of explanation the analog signal that undergoes this stages is referred to as analog signal.

The invention provides a method that includes: (i) exposing a first group of pixels located at a first location to light, during an intermediate exposure period, to provide analog signals representative of the light; and (ii) transferring the analog signals to a second group of pixels located at a second location; whereas a relationship between the first and second locations is responsive to an estimated inter-image shift.

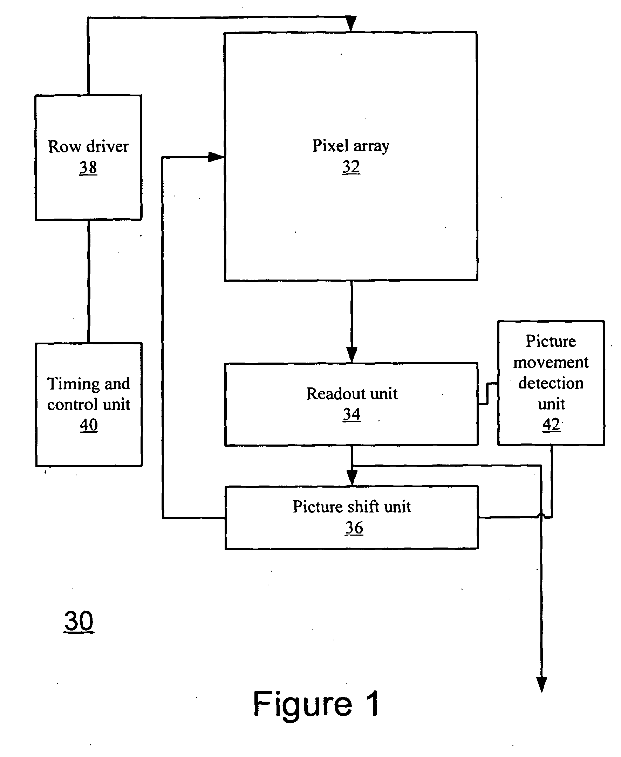

Figure 1 is a schematic diagram of an apparatus 30 for camera shake compensation, according to an embodiment of the invention.

According to an embodiment of the invention apparatus 30 of Figure 1 as well as other apparatuses described in this patent application, are capable of performing rotation operations, but said rotation usually requires relatively large analog memory.

Apparatus 30 includes a picture movement detection unit 42, a write back circuitry that includes a picture shift unit 36 and readout unit 34, timing and control unit 40 and a row driver 38. The pixel array 32 is connected to row driver 38, to readout unit 34 and to the picture shift unit 36. The picture shift unit 36 is also connected to the timing and control unit 40, to the picture movement detection unit 42 and to the readout unit 34, and also provides an output interface to apparatus 30. A picture acquired by apparatus 30 can be outputted via this output interface. The picture shift unit 36 may include an analog memory or may be connected to an analog memory.

The picture movement detection unit 42 is capable of estimating the relative movement between the pixel array and at least one object within the image acquired by the pixel array. The picture movement detection unit 42 can apply well-known algorithms for determining said movement. Conveniently, the picture movement detection unit 42 receives multiple output signals of the apparatus 30, usually multiple images and processes them to determine previous movement and estimate future movement. Picture movement detection unit 42 can determine the direction of that movement and its speed. Conveniently, the estimated movement is translated to an X axis and Y axis estimated movement components. These components are used to compensate for camera shake by determining which pixels shall receive the analog signal generated by other pixels.

The pixel array 32 is controlled such as to provide multiple intermediate images. Once a certain intermediate image is acquired it (or portions of said intermediate image) is sent to picture shift unit 36, via readout unit 34, to be temporarily stored and to be provided (conveniently during a write-back stage) to pixels in a manner that is responsive to the estimated movement.

The apparatus 30 facilitates long aggregate integration periods that include multiple short intermediate exposure periods. By shifting analog signals representative of previous intermediate images the apparatus 30 allows to provide sharp images even in low ambient light conditions.

Pixel array 32 includes multiple pixels. These pixels can be prior art pixels, such as those illustrated by the previously mentioned patents, but this is not necessarily so. For example, a pixel can include a light sensitive element (such as a photodiode, photo-gate or a phototransistor) that generates an analog signal in response to received light, as well as additional components, connected to the light sensitive element, that read that analog signal (for example by sensing voltage, current and the like) and send it to other components such as readout unit 34. The pixel is also capable to receive analog signals representative of a previous intermediate exposure period. These signals may be also referred to as write-back signals and the process of providing these signals to the pixels may be also referred to as a write-back process. Each write-back operation integrates new light information with previously acquired information resulting in an overall long aggregate integration period. The reception of a write back signal alter a condition of the pixel and especially a condition of the light sensitive element such as to reflect previous reception of light from other pixels.

The row driver 38 provides strobe signals to the pixel array 32 enabling read and write operation according to the timing provided by the timing and control unit 40. The readout unit 34 retrieves analog signals representative of the signals generated by the light sensitive elements of the pixels and may include analog and digital components. It may include amplifiers, noise reduction circuitry, analog to digital converters and the like.

The picture shift unit 36 stores analog signals that represent the light received by the pixels, shifts it according to the estimated motion (also referred to inter-image shift) and sends it, either directly or via the readout unit 34, back to the pixel array 32.

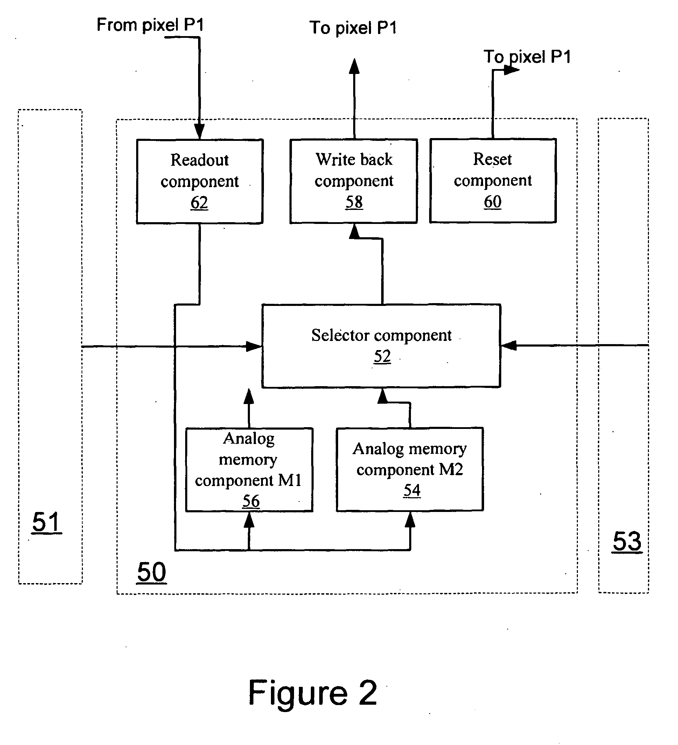

Figure 2 is a schematic illustration of a cell 50 of the picture shift unit 36, according to an embodiment of the invention. Each cell is selectively connected to a pixel that belongs to a certain column. Cell 50 is connected to pixel P1.

Cell 50 includes a selector component 52 as well as one or more memory components such as M1 54 and M2 56. The selector component can be connected to memory components of other cells. By selecting which memory component to connect to pixel P1 cell 50 performs an X-axis shift operation. The selector component 52 is connected to write back component 58 that is capable of providing the analog signal stored within the selected memory component to pixel P1. Pixel P1 is also connected to a reset component 60 capable of providing a reset signal to pixel P1, and is also connected to a readout component 62 capable of reading the content of pixel P1. Cell 50 is a part of a multiple cell arrangement that forms the picture shift unit 36. For example, cell 50 is placed between two identical cells 51 and 53 that are connected to pixels P0 and P2 that are adjacent to pixel P1.

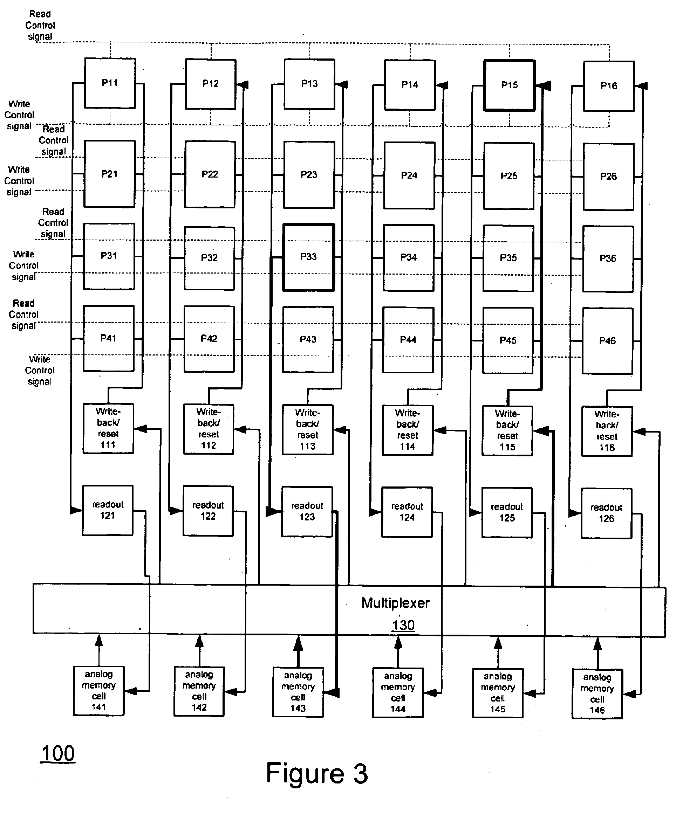

Figure 3 is a schematic diagram of a portion 100 of an apparatus 10' for camera shake compensation, according to an embodiment of the invention.

Portion 100 includes 4 x 6 pixels denoted P11 - P46, each adapted to receive a read control signal, a reset / write-back control signal, a reset signal or a write back signal and to output an output analog signal.

A first column of pixels P11 - P41 is connected to a first write-back/ reset component 111 and to a first readout component 121. A second column of pixels P12 - P42 is connected to a second write-back/ reset component 112 and to a second readout component 122. A third column of pixels P13 - P43 is connected to a third write-back/ reset component 113 and to a third read-out component 123. A forth column of pixels P14 - P44 is connected to a forth write-back/ reset component 114 and to a forth readout component 124. A fifth column of pixels P15 - P45 is connected to a fifth write-back/ reset component 115 and to a fifth readout component 125. A sixth column of pixels P16 - P46 is connected to a sixth write-back/ reset component 116 and to a sixth readout component 126.

The write-back/ reset components 111-116 are connected to analog memory components 141-146. The analog memory components 141-146 are connected to a multiplexer 130 that determines to which readout components to connect said analog memory components 141-146. For example, if the X axis estimated movement component is zero
then analog memory components 141-146 are connected to write-back/ reset components 111-116. If, for example, the X axis estimated movement component is two pixels to the right then the analog memory components 141-146 are connected via multiplexer 130 to write-back/ reset components 113-118.

The pixels receive control signals on a row basis, such that a row of pixels outputs analog signals in parallel to the readout component 121- 126.

The thick arrows illustrate a read operation from pixel P33 (actually the whole third row is read), to the third readout component 123 and the storage of that analog signal at a third analog memory component 143. The stored analog signal is sent, via multiplexer 130 to the fifth readout component 125, to the fifth write-back/ reset component 115 to pixel P15. It is noted that the content of pixels P31- P36 is written to pixels P13-P18.

The analog memory components usually include two or more rows of memory cells. The amount of rows determines that amount of Y-axis movement compensation. The amount of rows can also be responsive to the configuration of the pixel array. A color pixel array usually requires more rows that a single light pixel array.

A typical color pixel array configuration includes a grid of color filters that are placed in a mosaic pattern over the pixels so that only one of red, green or blue light reaches any given pixel. The most common color filter pattern used in single pixel array cameras is the Bayer pattern. In this pattern the pixel array includes 50% green pixels, 25% red pixels and 25% blue pixels. The pixels are arranged such that one row includes green pixels, each positioned between red pixels while an adjacent row includes green pixels, each positioned between blue pixels.

Write-back operations occur between pixels-of the same color. Accordingly, using a color pixel array requires at least one additional row of memory cells in comparison to a single color pixel array.

Portion 100 operates in a rolling shutter mode. Thus, the rows (or columns) of the pixel array are read, reset or written back to on a row-to-row basis. In a typical pixel array that includes hundreds of even more than a thousand rows, the duty cycle of each pixel row is very high and is limited by a relatively short reset, read or write-back operation. Conveniently, the determination of inter-pixel shift is executed during the read, reset or write back stages.

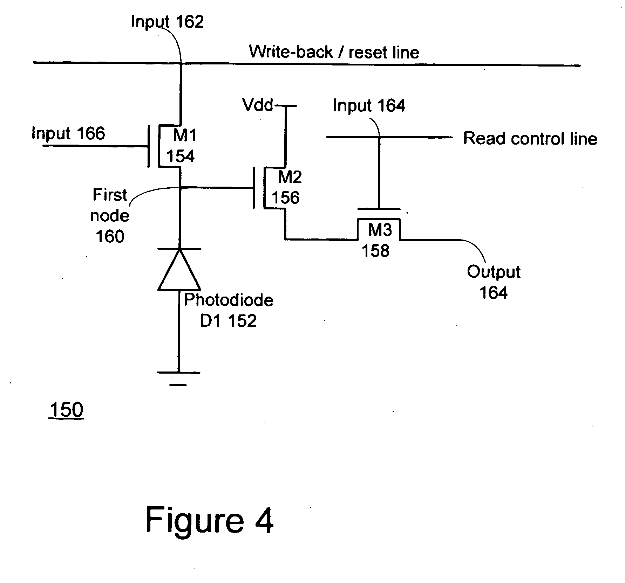

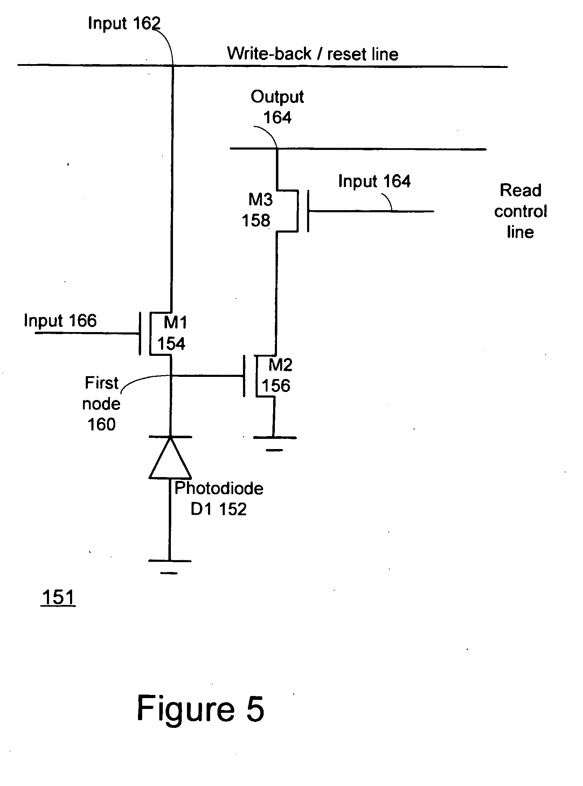

FIG. 4 illustrates pixel P11 150 according to an embodiment of the invention. It is assumed that pixel P11 is part of portion 100 of Figure 5. Pixel P11 includes a light sensitive element (such as D1 152) adapted to provide an analog signal in response to received light; and a first component (such as transistor M1) adapted to receive a write-back signal representative of previously received light and to alter a condition of the light sensitive element in response to the write-back signal. Conveniently, pixel P11 also includes a second component (such as transistors M2 156 and M3 158), capable of providing an output signal representative of the analog signal.

Pixel P11 includes a photodiode D1 152 that converts light into a photocurrent. D1 152 is connected to a first node 160 of pixel P11. P11 also includes a reset transistor M1 154, a buffering transistor M2 156 and a read transistor M3 158. The gate of M1 154 is adapted to receive a reset control signal via reset control input 166 of P11. The drain of M1 154 is adapted to receive a reset signal or an analog signal from first write-back/ reset component 111 via a write-back/reset input 162 of P11. The source of M1 154 is connected to the first node 160, as well as the gate of M2 156. The source of M2 156 is connected to the source of M3 158 while the drain of M2 156 is connected to supply source Vdd. The gate of M3 158 is adapted to receive a read control signal via read input 164 of P11. The drain of M3 158 provides a n analog output signal of P11 via an output node 164 of P11. When a reset or write back control signal arrives to the gate of M1 154 the voltage of the first node 160 is set to the voltage provided to reset/write-back input 162 of P11 minus a small drain source voltage Vds of M1 154. When the gate of M3 158 receives a read control signal it provides as an output signal of P11 a voltage that equals Vfn-Vt2-Vsd3, whereas Vfn is the voltage level of the first node 160, Vt2 is a threshold voltage of M2 156 and Vsd3 is a source drain voltage of M3 158.

Figure 5 illustrates pixel P12 151 according to another embodiment of the invention. Pixel P12 resembles pixel P11 but the source of M2 156 is grounded while the drain of M2 156 is connected to the drain of M2 156 is connected to the source of M3 158.

According to other embodiments of the invention pixels of other configurations can be used, including, for example, pixels of four transistors or pixels that are connected or selectively connected to feedback loops that include amplifiers or transistors for reducing thermal noise. The pixels can provide current that is representative of the received light.

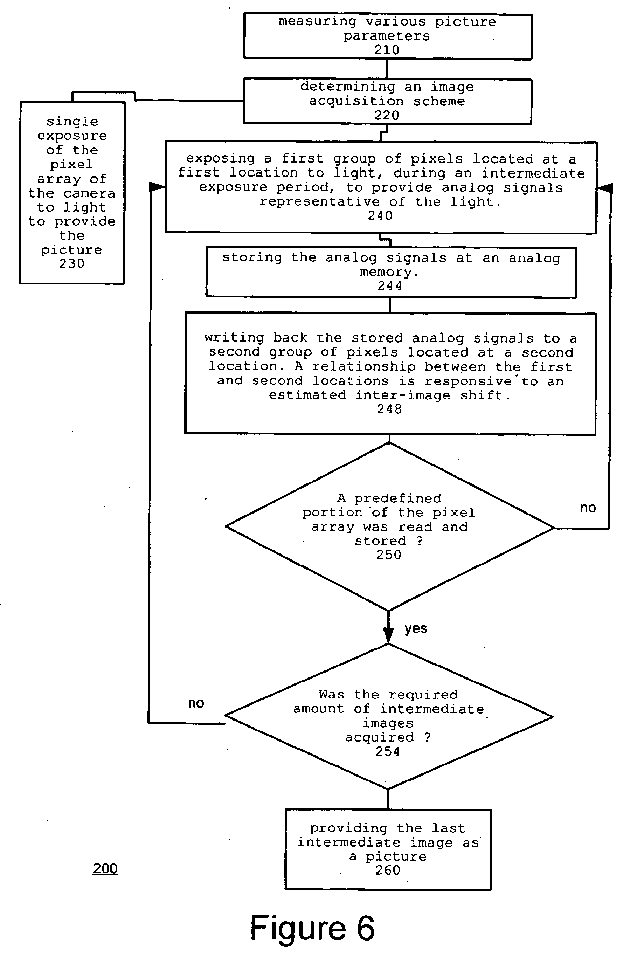

Figure 6 is a flow chart illustrating a method 200 for acquiring a picture, according to an embodiment of the invention.

Method 200 starts by stage 210 of measuring various picture parameters. These picture parameters may include an amount of ambient light, relative movement between a pixel array and an object, and the like.

There are various prior art methods for performing this stage. For example, the relative movement between the camera and an object can be measured by applying optical flow algorithms, block-matching algorithms, correlation based algorithms, Fourier Transform based algorithms, wavelet transform based algorithms. Some prior art algorithms process a full image, while others divide the image into a number of sub-images and analyze them separately. Some algorithms utilize small image areas of each image to determine the image movement. These small image areas are chosen according to various criteria, for example good or best contrast, color contrast, edges of objects, etc.

Stage 210 is followed by stage 220 of determining an image acquisition scheme. The determination is conveniently responsive to the amount of ambient light, a required aggregate exposure period and the relative movement.

The image acquisitions scheme can include a single shot, as illustrated by stage 230 that follows stage 220. A single shot means that the picture is acquired as a result of a single exposure of the pixel array of the camera to light.

The image acquisition scheme may include acquiring multiple intermediate images, as illustrated by stages 240-254 that follow stage 220. Each intermediate image is acquired during an intermediate exposure period. The length of the intermediate exposure period is selected to provide a sharp intermediate image. In other words, the intermediate exposure period is selected such that during that period the estimated relative movement will be below a predefined threshold (for example below 0.1 pixel). Conveniently, the intermediate exposure period is selected in response to the camera's limitations including its analog memory capacity (for example the amount of rows). Said limitation will be further discussed in relation to Figure 4.

Stage 240 includes exposing a first group of pixels located at a first location to light, during an intermediate exposure period, to provide analog signals representative of the light.

Stage 240 is followed by stage 244 of storing the analog signals at an analog memory.

Stage 244 is followed by stage 248 of writing back the stored analog signals to a second group of pixels located at a second location. A relationship between the first and second locations is responsive to an estimated inter-image shift.

Stage 248 is followed by query 250 of determining if a predefined portion of the pixel array was read and stored. For example this question may include determining if all the rows of a pixel array were exposed to light and read. If the answer is negative stage 250 is followed by another sequence of stages 240-248 during which other pixels of the array are exposed to light and read.

If the answer is positive than an intermediate image was formed and stage 250 is followed by query stage 254 of determining if the required amount of intermediate images was acquired. If the answer is positive stage 254 is followed by stage 260 as providing the last intermediate image as a picture. It is noted that only a portion of said picture can be provided.

If the answer is negative then there is a need to provide additional intermediate images. In such a case stage 254 is followed by stage 240. It is noted that the method can include updating the movement estimate according to the currently acquired intermediate image.

Variations, modifications, and other implementations of what is described herein will occur to those of ordinary skill in the art without departing from the invention as claimed.

## Claims

1. A method for providing a shake compensated image, comprising:
exposing (140) pixels of a pixel array (32) of a camera to light, during an aggregate integration period consisting of multiple intermediate exposure periods, to provide analog signals representative of the light; wherein a first group of pixels is located at a first location in the pixel array; and for each intermediate exposure period
storing (144) the analog signals from said first group of pixels at an analog memory;
wherein the method is **characterized by**:
writing (148) the stored analog signals to a second group of pixels of the pixel array that is located at a second location in the pixel array; wherein a relationship between the first and second locations is responsive to the estimated direction and speed of the inter-image shift.

2. The method of claim 1 whereas the stage of exposing is preceded by a stage of determining the length of the intermediate exposure period.

3. The method of claim 2 wherein the length of the intermediate exposure period responsive to the estimated inter-image shift.

4. The method of claim 2 wherein the length of the intermediate exposure period is responsive to a capacity of the analog memory.

5. The method of claim 1 wherein the steps of exposing, storing and writing are repeated to provide a picture.

6. The method of claim 1 wherein multiple iterations of the steps of exposing, storing and writing provide an intermediate image.

7. The method of claim 1 wherein the stages of steps of exposing, storing and writing are repeated until multiple intermediate images are provided.

8. The method of claim 7 wherein an amount of intermediate images is responsive to an aggregate exposure period.

9. The method of claim 1 wherein the first group of pixels is a pixel row.

10. The method of claim 1 wherein the first group of pixels is a pixel column.

11. The method according to Claim 1, wherein the exposing of the first group of pixel comprises exposing each first pixel located at a first location to light for the intermediate exposure period to provide an analog signal representative of the light;
storing the analog signal at an analog memory; and wherein the writing of the analog signals to the second group of pixels comprises writing the stored analog signal of the first pixel to to a second pixel located at a second pixel location; whereas a relationship between the first and second locations is responsive to an estimated inter-image shift.

12. The method of claim 11 wherein the first pixel differs from the second pixel.

13. The method of claim 11 wherein the first pixel equals the second pixel.

14. The method of claim 11 whereas the stored analog signal differs from a reset signal.

15. The method of claim 1 further comprising exposing the second group of pixels located at the second location to light, for further intermediate exposure period.

16. An imaging apparatus (30) for camera shake compensation, the apparatus comprising:
a pixel array (32) that comprises at least a first group of pixels and a second group of pixels, wherein the first group of pixels is located at a first location in the pixel array (32), and is adapted to receive light during an aggregate exposure period consisting of multiple intermediate exposure periods, and in response to provide analog signals representative of the light; and
an analog memory, adapted to store the analog signals from the first group of pixels;
wherein the apparatus is **characterized by**:
a write circuitry, adapted to write the stored analog signals to a second group of pixels located at a second location; wherein a relationship between the first and second locations is responsive to the estimated direction and speed of the inter-image shift.

17. The apparatus according to Claim 16, wherein each of the pixels of the first and second group of pixels is a pixel, comprising:
a light sensitive element adapted to provide an analog signal in response to received light; and
a first component adapted to receive a write signal representative of previously received light and to alter a condition of the light sensitive element in response to the write signal.

18. The apparatus of claim 17 further comprising a second component, capable of providing an output signal representative of the analog signal.

19. The apparatus of claim 16 further comprising a controller adapted to control the operation of the write circuitry, analog memory and first and second group of pixels.

20. The apparatus of claim 16 further comprising a controller adapted to estimate the inter-image shift.

21. The apparatus of claim 20 whereas the controller is further adapted to determine the length of the intermediate exposure period.

22. The apparatus of claim 21 wherein the length of the intermediate exposure period is responsive to the estimated inter-image shift.

23. The apparatus of claim 21 wherein the length of the intermediate exposure period is responsive to a capacity of the analog memory.

24. The apparatus of claim 16 wherein the apparatus is adapted to repeat an exposure of the first group of pixels to light, a storage of analog signals and a write of the analog signals to provide a picture.

25. The apparatus of claim 16 wherein apparatus comprises an array of pixels that comprises at least the first and second groups of pixels.

26. The apparatus of claim 25 whereas the apparatus is adapted to repeat an exposure of different groups of pixels to light, storage of analog signals and a write of the analog signals such as to provide an intermediate image.

27. The apparatus of claim 25 whereas the apparatus is adapted to repeat an exposure of different groups of pixels to light, storage of analog signals and a write operation of the analog signals such as to provide multiple intermediate images.

28. The apparatus of claim 27 wherein an amount of intermediate images is responsive to an aggregate exposure period.

29. The apparatus of claim 16 wherein the first group of pixels is a pixel row.

30. The apparatus of claim 16 wherein the first group of pixels is a pixel column.

31. The apparatus for camera shake compensation according to Claim 16,
wherein the first group of pixels and the second group of pixels are comprised in
a two dimensional array pixels, whereas multiple pixels of the array are adapted to receive light during an intermediate exposure period, and in response to provide analog signals representative of the light; and are further adapted to alter their condition in response to a reception of write signals representative of previously received light.

32. The apparatus of claim 31 whereas the first and second groups are pixel rows.

33. The apparatus of claim 31 whereas the first and second groups are pixel columns.

34. The apparatus of claim 31 adapted to repeat an exposure of various groups of pixels to light, a storage of analog signals and a write operation of the analog signals until a predefined portion of the pixel array receives write signals.

35. The apparatus of claim 31 wherein the apparatus is adapted to repeat an exposure of the first group of pixels to light, a storage of analog signals and a writing of the analog signals to provide a picture.

36. The apparatus of claim 31 whereas the apparatus is adapted to repeat an exposure of different groups of pixels to light, storage of analog signals and a writing of the analog signals such as to provide an intermediate image.

37. The apparatus of claim 31 whereas the apparatus is adapted to repeat an exposure of different groups of pixels to light, storage of analog signals and a writing of the analog signals such as to provide multiple intermediate images.

## Patentansprüche

1. Verfahren zum Bereitstellen eines verwacklungskompensierten Bildes, umfassend:
Aussetzen (140) von Pixeln eines Pixelarrays (32) einer Kamera Licht während eines aggregierten Integrationszeitintervalls, das aus mehreren Zwischenaussetzungszeitintervallen besteht, um ein analoges Signal zur Verfügung zu stellen, das für das Licht repräsentativ ist, wobei eine erste Gruppe von Pixeln in einem ersten Ort in dem Pixelarray angeordnet ist, und
für jedes Zwischenaussetzungszeitintervall Speichern (144) der analogen Signale aus der ersten Gruppe von Pixeln in einem analogen Speicher,
wobei das Verfahren **gekennzeichnet ist durch**:
Schreiben (148) der gespeicherten analogen Signale in eine zweite Gruppe von Pixeln des Pixelarrays, die in einem zweiten Ort in dem Pixelarray angeordnet ist, wobei eine Beziehung zwischen dem ersten und dem zweiten Ort auf die abgeschätzte Richtung und die Geschwindigkeit des Zwischenbildversatzes reagiert.

2. Verfahren nach Anspruch 1, wobei dem Arbeitsgang des Aussetzens der Arbeitsgang des Bestimmens der Länge des Zwischenaussetzungszeitintervalls vorrausgeht.

3. Verfahren nach Anspruch 2, wobei die Länge des Zwischenaussetzungszeitintervalls auf den abgeschätzten Zwischenbildversatz reagiert.

4. Verfahren nach Anspruch 2, wobei die Länge des Zwischenaussetzungszeitintervalls auf eine Kapazität des analogen Speichers reagiert.

5. Verfahren nach Anspruch 1, wobei die Schritte des Aussetzens, Speicherns und Schreibens wiederholt werden, um ein Bild bereitzustellen.

6. Verfahren nach Anspruch 1, wobei mehrere Iterationen der Schritte des Aussetzens, Speicherns und Schreibens ein Zwischenbild bereitstellen.

7. Verfahren nach Anspruch 1, wobei die Arbeitsgänge der Schritte des Aussetzens, Speicherns und Schreibens wiederholt werden, bis mehrere Zwischenbilder bereitgestellt sind.

8. Verfahren nach Anspruch 7, wobei eine Anzahl von Zwischenbildern auf ein aggregiertes Aussetzungszeitintervall reagiert.

9. Verfahren nach Anspruch 1, wobei die erste Gruppe von Pixeln eine Pixelzeile ist.

10. Verfahren nach Anspruch 1, wobei die erste Gruppe von Pixeln eine Pixelspalte ist.

11. Verfahren nach Anspruch 1, wobei das Aussetzen der ersten Gruppe von Pixeln das Aussetzen jedes ersten Pixels, das an einem ersten Ort angeordnet ist, dem Licht für die Zwischenaussetzungsperiode umfaßt, um ein analoges Signal bereitzustellen, das für das Licht repräsentativ ist,
Speichern des analogen Signals in einem analogen Speicher, und wobei das Schreiben der analogen Signale in die zweite Gruppe von Pixeln das Schreiben des gespeicherten analogen Signals des ersten Pixels in ein zweites Pixel umfaßt, das an einem zweiten Pixelort angeordnet ist, während eine Beziehung zwischen den ersten und zweiten Pixelorten auf einen abgeschätzten Zwischenbildversatz reagiert.

12. Verfahren nach Anspruch 11, wobei sich das erste Pixel von dem zweiten Pixel unterscheidet.

13. Verfahren nach Anspruch 11, wobei das erste Pixel dem zweiten Pixel entspricht.

14. Verfahren nach Anspruch 11, wobei sich das gespeicherte analoge Signal von einem Rücksetzsignal unterscheidet.

15. Verfahren nach Anspruch1, ferner umfassend das Aussetzen der zweiten Gruppe von Pixeln, die an dem zweiten Ort angeordnet sind, dem Licht für weitere Zwischenaussetzungszeitintervalle.

16. Bildgebende Vorrichtung (30) zur Kompensation von Kameraverwackeln, wobei die Vorrichtung umfaßt:
ein Pixelarray (32), das wenigstens eine erste Gruppe von Pixeln und eine zweite Gruppe von Pixeln umfaßt, wobei die erste Gruppe von Pixeln an einem ersten Ort in dem Pixelarray (32) angeordnet und dazu ausgebildet ist, während eines aggregierten Aussetzungszeitintervalls, das aus mehreren Zwischenaussetzungszeitintervallen besteht, Licht zu empfangen und als Reaktion darauf analoge Signale bereitzustellen, die für das Licht repräsentativ sind, und
einen analogen Speicher, der dazu ausgebildet ist, die analogen Signale aus der ersten Gruppe von Pixeln zu speichern,
wobei die Vorrichtung **gekennzeichnet ist durch**:
eine Schreibschaltung, die dazu ausgebildet ist, die gespeicherten analogen Signale in eine zweite Gruppe von Pixeln, die an einen zweiten Ort angeordnet sind, zu schreiben, wobei eine Beziehung zwischen den ersten und zweiten Orten auf die geschätzte Richtung und Geschwindigkeit des Zwischenbildversatzes reagiert.

17. Vorrichtung nach Anspruch 16, wobei jedes der Pixel der ersten und zweiten Gruppe von Pixeln ein Pixel ist, das umfaßt:
ein lichtempfindliches Element, das dazu ausgebildet ist, als Reaktion auf empfangenes Licht ein analoges Signal bereitzustellen, und
eine erste Komponente, die dazu ausgebildet ist, ein Schreibsignal zu empfangen, das für zuvor empfangenes Licht repräsentativ ist, und einen Zustand des lichtempfindlichen Elementes in Reaktion auf das Schreibsignal zu verändern.

18. Vorrichtung nach Anspruch 17, ferner umfassend eine zweite Komponente, die in der Lage ist, ein Ausgabesignal bereitzustellen, das für das analoge Signal repräsentativ ist.

19. Vorrichtung nach Anspruch 16, ferner umfassend ein Steuergerät, das dazu ausgebildet ist, den Betrieb der Schreibschaltung, des analogen Speichers und der ersten und zweiten Gruppe von Pixeln zu steuern.

20. Vorrichtung nach Anspruch 16, ferner umfassend ein Steuergerät, das dazu ausgebildet ist, den Zwischenbildversatz abzuschätzen.

21. Vorrichtung nach Anspruch 20, wobei das Steuergerät ferner dazu ausgebildet ist, die Länge der Zwischenaussetzungszeitintervalle zu bestimmen.

22. Vorrichtung nach Anspruch 21, wobei die Länge der Zwischenaussetzungszeitintervalle auf den abgeschätzten Zwischenbildversatz reagiert.

23. Vorrichtung nach Anspruch 21, wobei die Länge der Zwischenaussetzungszeitintervalle auf eine Kapazität des analogen Speichers reagiert.

24. Vorrichtung nach Anspruch 16, wobei die Vorrichtung dazu ausgebildet ist, ein Aussetzen der ersten Gruppe von Pixeln Licht, ein Speichern von analogen Signalen und ein Schreiben der analogen Signale zu wiederholen, um ein Bild bereitzustellen.

25. Vorrichtung nach Anspruch 16, wobei die Vorrichtung ein Pixelarray umfaßt, das zumindest die ersten und zweiten Gruppen von Pixeln enthält.

26. Vorrichtung nach Anspruch 25, wobei die Vorrichtung dazu ausgebildet ist, ein Aussetzen der verschiedenen Gruppen von Pixeln Licht, Speichern der analogen Signale und ein Schreiben der analogen Signale zu wiederholen, um so ein Zwischenbild bereitzustellen.

27. Vorrichtung nach Anspruch 25, wobei die Vorrichtung dazu ausgebildet ist, ein Aussetzen der verschiedenen Gruppen von Pixeln Licht, Speichern der analogen Signale und einen Schreibarbeitsgang der analogen Signale zu wiederholen, um mehrere Zwischenbilder zur Verfügung zu stellen.

28. Vorrichtung nach Anspruch 27, wobei eine Anzahl von Zwischenbildern auf ein aggregiertes Zwischenaussetzungszeitintervall reagiert.

29. Vorrichtung nach Anspruch 16, wobei die erste Gruppe von Pixeln eine Pixelzeile ist.

30. Vorrichtung nach Anspruch 16, wobei die erste Gruppe von Pixeln eine Pixelspalte ist.

31. Vorrichtung zur Kompensation von Kameraverwackeln gemäß Anspruch 16, wobei die erste Gruppe von Pixeln und die zweite Gruppe von Pixeln in einem zweidimensionalen Pixelarray enthalten sind, wobei mehrere Pixel des Arrays dazu ausgebildet sind, Licht während eines Zwischenaussetzungszeitintervalls zu empfangen und als Reaktion darauf analoge Signale bereitzustellen, die repräsentativ für das Licht sind, und die weiter dazu ausgebildet sind, ihren Zustand als Reaktion auf ein Empfangen von Schreibsignalen, die repräsentativ für zuvor empfangenes Licht sind, zu ändern.

32. Vorrichtung nach Anspruch 31, wobei die ersten und zweiten Gruppen Pixelzeilen sind.

33. Vorrichtung nach Anspruch 31, wobei die ersten und zweiten Gruppen Pixelspalten sind.

34. Vorrichtung nach Anspruch 31, dazu ausgebildet, ein Aussetzen der verschiedenen Gruppen von Pixeln Licht, ein Speichern von analogen Signalen und eine Schreiboperation der analogen Signale zu wiederholen, bis ein vorbestimmter Teil des Pixelarrays Schreibsignale empfängt.

35. Vorrichtung nach Anspruch 31, wobei die Vorrichtung dazu ausgebildet ist, ein Aussetzen der ersten Gruppe von Pixeln Licht, ein Speichern von analogen Signalen und ein Schreiben der analogen Signale zu wiederholen, um ein Bild bereitzustellen.

36. Vorrichtung nach Anspruch 31, wobei die Vorrichtung dazu ausgebildet ist, ein Aussetzen der verschiedenen Gruppen von Pixeln Licht, Speichern von analogen Signalen und ein Schreiben der analogen Signale zu wiederholen, um so ein Zwischenbild bereitzustellen.

37. Vorrichtung nach Anspruch 31, wobei die Vorrichtung dazu ausgebildet ist, ein Aussetzen der verschiedenen Gruppen von Pixeln Licht, Speichern von analogen Signalen und ein Schreiben der analogen Signale zu wiederholen, um so mehrere Zwischenbilder bereitzustellen.

## Revendications

1. Procédé de fourniture d'une image dont les secousses ont été compensées, comprenant :
l'exposition à la lumière (140) des pixels d'une matrice de pixels (32) d'une caméra pendant une période d'intégration cumulée constituée de plusieurs périodes d'exposition intermédiaires pour fournir des signaux analogiques dépendant de la lumière ; dans lequel un premier groupe de pixels est situé à un premier emplacement dans la matrice de pixels ; et pendant chaque période d'exposition intermédiaire
l'enregistrement (144) dans une mémoire analogique des signaux analogiques dudit premier groupe de pixels ;
dans lequel le procédé est **caractérisé par** :
l'écriture (148) des signaux analogiques enregistrés dans un deuxième groupe de pixels de la matrice de pixels, qui est situé à un deuxième emplacement dans la matrice de pixels ; dans lequel la relation entre les premier et deuxième emplacements dépend de la direction et de la vitesse du décalage entre images estimé.

2. Procédé selon la revendication 1, dans lequel l'étape d'exposition est précédée d'une étape de détermination de la durée de la période d'exposition intermédiaire.

3. Procédé selon la revendication 2, dans lequel la durée de la période d'exposition intermédiaire dépend du décalage entre images estimé.

4. Procédé selon la revendication 2, dans lequel la durée de la période d'exposition intermédiaire dépend de la capacité de la mémoire analogique.

5. Procédé selon la revendication 1, dans lequel les étapes d'exposition, d'enregistrement et d'écriture sont répétées de manière à fournir une image.

6. Procédé selon la revendication 1, dans lequel plusieurs itérations des étapes d'exposition, d'enregistrement et d'écriture fournissent une image intermédiaire.

7. Procédé selon la revendication 1, dans lequel les étapes d'exposition, d'enregistrement et d'écriture sont répétées jusqu'à ce que plusieurs images intermédiaires soient fournies.

8. Procédé selon la revendication 7, dans lequel le nombre d'images intermédiaires dépend d'une période d'exposition cumulée.

9. Procédé selon la revendication 1, dans lequel le premier groupe de pixels est une rangée de pixels.

10. Procédé selon la revendication 1, dans lequel le premier groupe de pixels est une colonne de pixels.

11. Procédé selon la revendication 1, dans lequel l'exposition à la lumière du premier groupe de pixels comprend l'exposition de chaque premier pixel situé à un premier emplacement pendant la période d'exposition intermédiaire pour fournir un signal analogique dépendant de la lumière ;
l'enregistrement du signal analogique dans une mémoire analogique ; et dans lequel l'écriture des signaux analogiques dans le deuxième groupe de pixels comprend l'écriture du signal analogique enregistré du premier pixel dans un deuxième pixel situé à un deuxième emplacement de pixel ; dans lequel la relation entre les premier et deuxième emplacements dépend du décalage entre images estimé.

12. Procédé selon la revendication 11, dans lequel le premier pixel diffère du deuxième pixel.

13. Procédé selon la revendication 11, dans lequel le premier pixel est identique au deuxième pixel.

14. Procédé selon la revendication 11, dans lequel le signal analogique enregistré diffère d'un signal de réinitialisation.

15. Procédé selon la revendication 1, comprenant en outre l'exposition à la lumière du deuxième groupe de pixels situés au deuxième emplacement, pendant une étape d'exposition intermédiaire supplémentaire.

16. Dispositif de formation d'images (30) pour compenser les secousses d'une caméra, le dispositif comprenant :
une matrice de pixels (32) comprenant au moins un premier groupe de pixels et un deuxième groupe de pixels, dans lequel le premier groupe de pixels est situé à un premier emplacement dans la matrice de pixels (32) et est adapté à recevoir de la lumière pendant une période d'exposition cumulée constituée de plusieurs périodes d'exposition intermédiaires et en réponse, à fournir des signaux analogiques dépendant de la lumière ; et
une mémoire analogique, adaptée à enregistrer les signaux analogiques provenant du premier groupe de pixels ;
dans lequel le dispositif est **caractérisé par** :
un circuit d'écriture, adapté à écrire les signaux analogiques enregistrés dans un deuxième groupe de pixels situé à un deuxième emplacement ; dans lequel la relation entre les premier et deuxième emplacements dépend de la direction et de la vitesse du décalage entre images estimé.

17. Dispositif selon la revendication 16, dans lequel chacun des pixels des premier et deuxième groupes de pixels est un pixel comprenant :
un élément sensible à la lumière adapté à fournir un signal analogique en réponse à la lumière reçue ; et
un premier composant adapté à recevoir un signal d'écriture dépendant de la lumière précédemment reçue et à modifier l'état de l'élément sensible à la lumière en réponse au signal d'écriture.

18. Dispositif selon la revendication 17, comprenant en outre un deuxième composant, capable de fournir un signal de sortie dépendant du signal analogique.

19. Dispositif selon la revendication 16, comprenant en outre un contrôleur adapté à contrôler le fonctionnement du circuit d'écriture, de la mémoire analogique et des premier et deuxième groupes de pixels.

20. Dispositif selon la revendication 16, comprenant en outre un contrôleur adapté à estimer le décalage entre images.

21. Dispositif selon la revendication 20, dans lequel le contrôleur est adapté en outre à déterminer la durée de la période d'exposition intermédiaire.

22. Dispositif selon la revendication 21, dans lequel la durée de la période d'exposition intermédiaire dépend du décalage entre images estimé.

23. Dispositif selon la revendication 21, dans lequel la durée de la période d'exposition intermédiaire dépend de la capacité de la mémoire analogique.

24. Dispositif selon la revendication 16, dans lequel le dispositif est adapté à répéter l'exposition à la lumière du premier groupe de pixels, l'enregistrement de signaux analogiques et l'écriture des signaux analogiques pour fournir une image.

25. Dispositif selon la revendication 16, dans lequel le dispositif comprend une matrice de pixels comprenant au moins les premier et deuxième groupes de pixels.

26. Dispositif selon la revendication 25, dans lequel le dispositif est adapté à répéter l'exposition à la lumière de différents groupes de pixels, l'enregistrement de signaux analogiques et l'écriture des signaux analogiques de façon à fournir une image intermédiaire.

27. Dispositif selon la revendication 25, dans lequel le dispositif est adapté à répéter l'exposition à la lumière de différents groupes de pixels, l'enregistrement de signaux analogiques et l'opération d'écriture des signaux analogiques de façon à fournir plusieurs images intermédiaires.

28. Dispositif selon la revendication 27, dans lequel le nombre d'images intermédiaires dépend de la période d'exposition cumulée.

29. Dispositif selon la revendication 16, dans lequel le premier groupe de pixels est une rangée de pixels.

30. Dispositif selon la revendication 16, dans lequel le premier groupe de pixels est une colonne de pixels.

31. Dispositif de compensation des secousses d'une caméra selon la revendication 16, dans lequel le premier groupe de pixels et le deuxième groupe de pixels sont constitués
de pixels d'une matrice bidimensionnelle, plusieurs pixels de la matrice étant adaptés à recevoir de la lumière pendant une période d'exposition intermédiaire et, en réponse à la fourniture de signaux analogiques dépendant de la lumière, sont adaptés en outre à modifier leurs états en réponse à la réception de signaux d'écriture dépendant de la lumière précédemment reçue.

32. Dispositif selon la revendication 31, dans lequel les premier et deuxième groupes sont des rangées de pixels.

33. Dispositif selon la revendication 31, dans lequel les premier et deuxième groupes sont des colonnes de pixels.

34. Dispositif selon la revendication 31, adapté à répéter l'exposition à la lumière de différents groupes de pixels, l'enregistrement de signaux analogiques et l'opération d'écriture des signaux analogiques jusqu'à ce qu'une partie prédéfinie de la matrice de pixels ait reçu des signaux d'écriture.

35. Dispositif selon la revendication 31, dans lequel le dispositif est adapté à répéter l'exposition à la lumière du premier groupe de pixels, l'enregistrement de signaux analogiques et l'écriture des signaux analogiques pour fournir une image.

36. Dispositif selon la revendication 31, dans lequel le dispositif est adapté à répéter l'exposition à la lumière de différents groupes de pixels, l'enregistrement de signaux analogiques et l'écriture des signaux analogiques de façon à fournir une image intermédiaire.

37. Dispositif selon la revendication 31, dans lequel le dispositif est adapté à répéter l'exposition à la lumière de différents groupes de pixels, l'enregistrement de signaux analogiques et l'écriture des signaux analogiques de façon à fournir plusieurs images intermédiaires.
